# EUROPEAN PATENT APPLICATION

(11) **EP 4 358 124 A1**
(43) Date of publication of application: **24.04.2024**
(21) Application number: 23195573.3
(22) Date of filing: 06.09.2023
(51) Int. Cl.: H01L 21/8238, H01L 21/84, H01L 27/092, H01L 27/12, H01L 29/10

(54) **DEVICE WITH LATERALLY GRADED CHANNEL REGION**

(30) Priority: 18.10.2022 US 202217968404
(71) Applicant: GlobalFoundries U.S. Inc., Malta, NY 12020 (US)
(72) Inventor: MULFINGER, George R., Malta, NY, 12020 (US)
(74) Representative: Lambacher, Michael

(57) **Abstract**

The present disclosure relates to semiconductor structures and, more particularly, to a device with a laterally graded channel region and methods of manufacture. The structure includes a PFET region with a laterally graded semiconductor channel region under a gate material.

## Description

### BACKGROUND

The present disclosure relates to semiconductor structures and, more particularly, to a device with a laterally graded channel region and methods of manufacture.

A silicon-on-insulator substrate permits device operation at significantly higher speeds with improved electrical isolation and reduced electrical losses in comparison with field-effect transistors built using a bulk silicon wafer. Generally, a silicon-on-insulator substrate includes a thin device layer of semiconductor material, a substrate, and a buried oxide layer physically separating and electrically isolating the device layer from the substrate. Contingent on the thickness of the device layer, a field-effect transistor may operate in a fully depleted mode in which a depletion layer in the channel region extends fully to the buried oxide layer when typical control voltages are applied to the gate electrode.

The channel region of a fully depleted p-type field-effect transistor may be composed of silicon-germanium. A conventional approach for forming the silicon-germanium channel region is to grow an epitaxial silicon-germanium layer on a section of the device layer and to perform a thermal condensation process. Germanium is transported from the epitaxial silicon-germanium layer to the device layer and throughout the channel region down to the buried oxide layer. The silicon-germanium channel region formed by the thermal condensation process may be prone to strain relaxation and broken bonds at an interface with the buried oxide layer. The broken bonds may elevate the interface trap density at the interface, and the strain relaxation may impact device performance through a loss of carrier mobility. To improve this issue, in known solutions, the silicon-germanium channel region may have a vertical gradient of a percentage concentration of germanium (Ge%).

### SUMMARY

In an aspect of the disclosure, a structure comprises a PFET region comprising a laterally graded semiconductor channel region under a gate material.

Additional features of the structure are set forth in dependent claims 2 to 9.

In an aspect of the disclosure, a structure comprises: a PFET device with a channel region comprising a laterally graded semiconductor-on-insulator material; another device with a channel region comprising a non-laterally graded semiconductor-on insulator-material; and a trench isolation structure isolating the PFET device from the other device.

Additional features of the structure are set forth in dependent claims 11 to 14.

In an aspect of the disclosure, a method comprises: forming a PFET device with a channel region comprising a laterally graded semiconductor-on-insulator material; forming an NFET device with a channel region comprising a non-laterally graded semiconductor-on-insulator material; and forming a trench isolation structure isolating the PFET device from the NFET device.

### BRIEF DESCRIPTION OF THE DRAWINGS

The present disclosure is described in the detailed description which follows, in reference to the noted plurality of drawings by way of non-limiting examples of exemplary embodiments of the present disclosure.
FIG. 1A shows a top view of a structure with a graded channel region in accordance with aspects of the present disclosure.
FIG. 1B shows a cross-sectional view of the structure of FIG. 1A along line "A"-"A".
FIGS. 2A-2E show fabrication processes of manufacturing the structure shown in FIGS. 1A and 1B.

### DETAILED DESCRIPTION

The present disclosure relates to semiconductor structures and, more particularly, to a device with a laterally graded channel region and methods of manufacture. More specifically, the structure includes a device with a laterally graded Silicon-Germanium channel (cSiGe) layer. In embodiments, the device may be a high voltage threshold (HVT) PFET using fully depleted semiconductor-on-insulator technology. Advantageously, the use of the laterally graded cSiGe layer significantly improves device performance compared to conventional devices, e.g., improves Ion vs. Ioff performance. In addition, fabrication processes eliminate a masking step required in conventional fabrication processes, while also allowing Vtsat to be independently tuned.

In more specific embodiments, the device may be a high threshold voltage PFET. In embodiments, the PFET may include a reduced Ge% at the boundary of the channel region. In further embodiments, the Ge% may be graded horizontal in the channel region of the PFET device such that a lower Ge% is proximate an NFET region. The Ge% may be tuned for different device performances by lithography processes as described herein. For example, with the processes described herein, it is now possible to provide selective inclusion of cSiGe in the active channel region to form a lateral Ge% grading.

The structure of the present disclosure can be manufactured in a number of ways using a number of different tools. In general, though, the methodologies and tools are used to form structures with dimensions in the micrometer and nanometer scale. The methodologies, i.e., technologies, employed to manufacture the structure of the present disclosure have been adopted from integrated circuit (IC) technology. For example, the structures are built on wafers and are realized in films of material patterned by photolithographic processes on the top of a wafer. In particular, the fabrication of the structure uses three basic building blocks: (i) deposition of thin films of material on a substrate, (ii) applying a patterned mask on top of the films by photolithographic imaging, and (iii) etching the films selectively to the mask. In addition, precleaning processes may be used to clean etched surfaces of any contaminants, as is known in the art. Moreover, when necessary, rapid thermal anneal processes may be used to drive-in dopants or material layers as is known in the art.

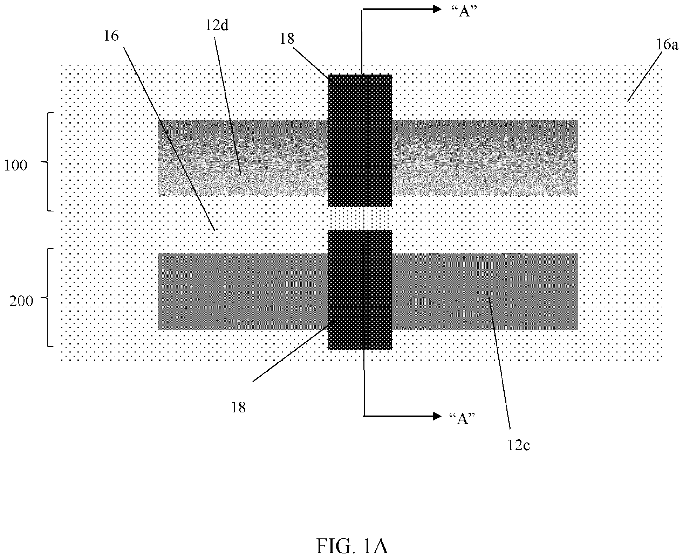

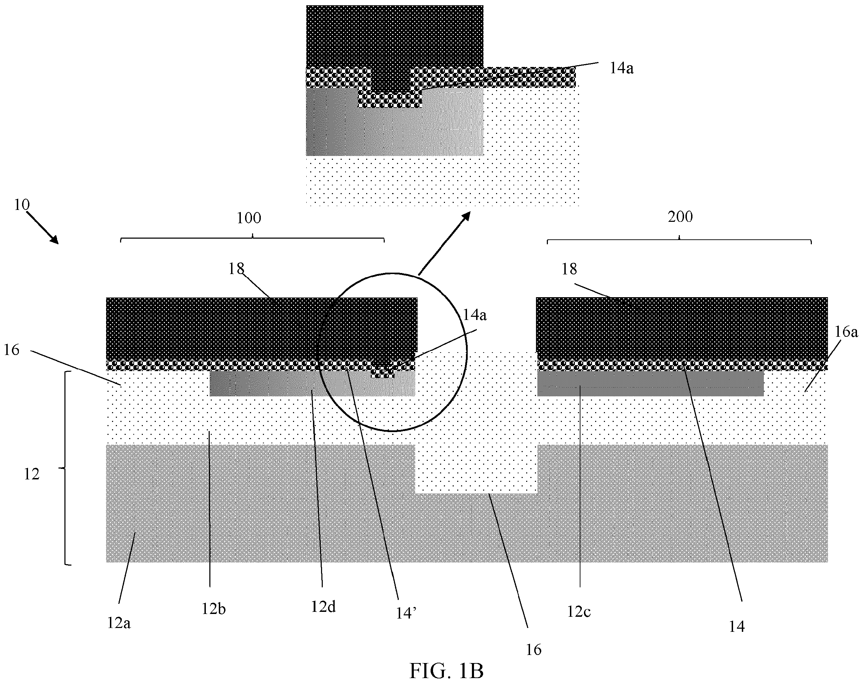

FIG. 1A shows a top view of a structure and FIG. 1B shows a cross-sectional view of the structure of FIG. 1A along line "A"-"A" in accordance with aspects of the present disclosure. More specifically, the structure 10 shown in FIGS. 1A and 1B includes a substrate 12. In embodiments, the substrate 12 may be fully depleted semiconductor-on-insulator (FSDOI) technology comprising a handle substrate 12a, a buried insulator layer (i.e., substrate) 12b and top semiconductor layers 12c, 12d isolated from each other by a shallow trench isolation structure 16. Shallow trench isolation structures 16a may be used to surround a PFET region 100 and NFET region 200. In embodiments, reference numeral 200 may also represent a non-graded cSiGe PFET.

The handle substrate 12a may include a semiconductor material such as, for example, Si, Ge, SiGe, SiC, SiGeC, a III-V compound semiconductor, an II-VI compound semiconductor or any combinations thereof. The handle substrate 12a may preferably be a single crystalline p-type semiconductor substrate. The handle substrate 12a provides mechanical support to the buried insulator layer 12b and the top semiconductor layers 12c, 12d.

The buried insulator layer 12b may include a dielectric material such as silicon dioxide, silicon nitride, silicon oxynitride, boron nitride or a combination thereof. In preferred embodiments, the buried insulator layer 12b may be a buried oxide material, e.g., BOX, formed by a deposition process, such as chemical vapor deposition (CVD), plasma enhanced CVD (PECVD) or physical vapor deposition (PVD). In alternative embodiments, the buried insulator layer 12b may be formed using a thermal growth process or oxygen implantation processes as is known in the art.

The top semiconductor layers 12c, 12d may be fully depleted semiconductor-on-insulator materials. In more specific embodiments, the top semiconductor layer 12c may comprise a silicon channel (cSi); whereas the top semiconductor layer 12d may comprise cSiGe with a laterally graded Ge%. The top semiconductor layer 12c may be a channel region for an NFET region 200 and the top semiconductor layer 12d may be a channel region for a PFET region 100.

In embodiments, the Ge% may be tuned along the width of the channel region of the PFET region 100, with a lower Ge% closest to the shallow trench isolation structure 16 at a boundary between the NFET region 200 and the PFET region 100 and a higher Ge% farther away from such boundary. It should be understood by those of ordinary skill in the art that the Ge% may be tuned laterally (e.g., horizontally along the width of the channel region) in the top semiconductor layer 12d with different Ge% in order to tune/increase Vt of the PFET region 100. For example, Vt targeting is achievable by a net reduction in Ge%, with Ioff vs. Vtsat improvement due to a lower net Ge%. Also, increased Ioff vs. Ieff performance can be achieved with adjustment of the Ge%, i.e., rather than relying on channel or well implant to achieve Vt targeting.

Still referring to FIGS. 1A and 1B, an insulator layer 14, 14' may be provided over the channel regions, e.g., top semiconductor layer 12c and top semiconductor layer 12d. In embodiments, the insulator layer 14, 14' may be an oxide or high-k dielectric material. A notch or protuberance 14a extends within the top semiconductor layer 12d, e.g., a notch 14a at an upper surface of the top semiconductor layer 12d. In embodiments, the notch or protuberance 14a conformally contains the gate dielectric and gate material 18. The gate material 18 may be a gate metal or a polysilicon material. The notch or protuberance 14a may be provided at a transition point of the Ge% within the top semiconductor layer 12d, where a lower Ge% is provided on a side closest to the shallow trench isolation structure 16 at the boundary of the NFET region 200 and the PFET 100. More specifically, the notch or protuberance 14a may be present at a cSi/cSiGe boundary.

The gate material 18 may be provided on the insulator layer 14, 14' over the channel regions, e.g., top semiconductor layers 12c, 12d of the PFET region 100 and NFET region 200. The gate material 18 may extend partially within the conformally formed notch 14a, and may be any known workfunction materials or combinations thereof used in the PFET region 100 and the NFET region 200. For example, the workfunction materials may include any suitable metals such as, but not limited to, Ti, TiAlC, Al, TiAl, TaN, TaAlC, TiN, TiC, TaC and Co or combinations thereof. The workfunction materials may be formed by CVD, PVD including sputtering, atomic layer deposition (ALD) or other suitable method, followed by a patterning process as further described below.

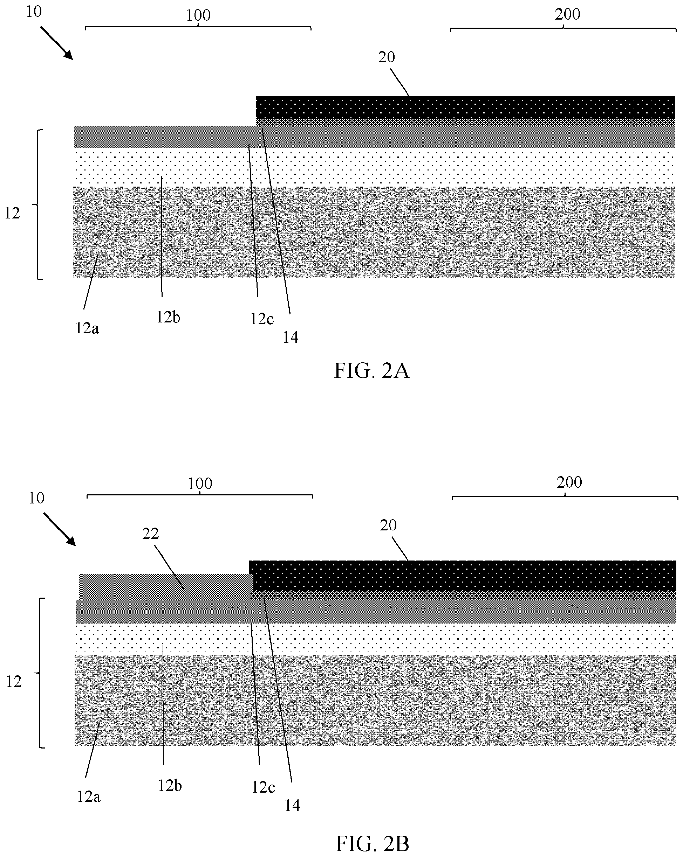

FIGS. 2A-2E show fabrication processes of manufacturing the structure 10 of FIGS. 1A and 1B. In FIG. 2A, an insulator layer 14 and masking layer 20 may be formed on the substate 12 and more particularly on the semiconductor-on-insulator material 12c. In embodiments, at this fabrication stage, the semiconductor-on-insulator material 12c may be fully depleted cSi. The insulator layer 14 may be a pad oxide that is deposited by a conventional deposition process, e.g., CVD. The mask layer 20 may be a pad nitride material deposited by a conventional deposition process, e.g., CVD.

The insulator layer 14 and mask layer 20 may be patterned to overlap onto a portion of the PFET region 100 of the structure 10. For example, through the use of conventional lithography and etching processes, the insulator layer 14 and mask layer 20 may be patterned with a portion of the insulator layer 14 and mask layer 20 remaining over the PFET region 100 of the structure 10. The overlap of the insulator layer 14 and mask layer 20 on the PFET side of the 100 may be tuned to assist in the formation of the laterally graded cSiGe channel of the PFET 100. For example, as described herein, by adjusting the extent of the overlap of the insulator layer 14 and mask layer 20, it is possible to tune the Ge% in the channel of the PFET region 100.

In FIG. 2B, a cSiGe material 22 may be provided over the exposed portion of the semiconductor-on-insulator material 12c on the PFET region 100 of the structure 10. The cSiGe material 22 may be epitaxially grown on the semiconductor-on-insulator material 12c, with the insulator layer 14 and mask layer 20 preventing growth of this material over the NFET region 200 of the structure 10.

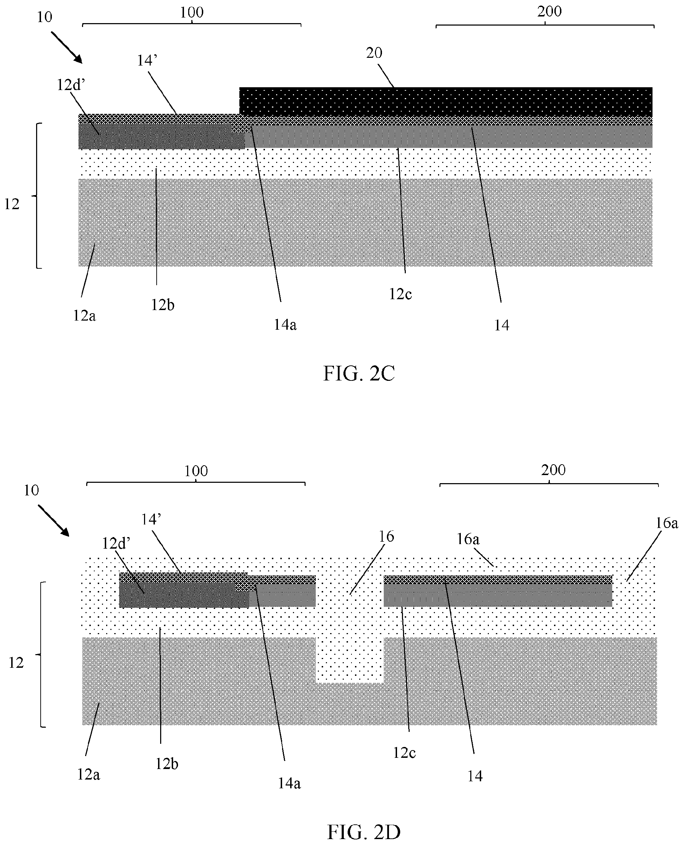

In FIG. 2C, the structure 10 undergoes a thermal condensation process to drive the cSiGe material 22 into the semiconductor-on-insulator material 12c on the PFET region 100 of the structure 10. In embodiments, the thermal condensation process is a thermal oxidation process which results in Ge material being transported from the epitaxial cSiGe to the device layer, e.g., channel region of the PFET region 100, forming cSiGe layer 12d'. The thermal oxidation process will also result in the cSiGe material converting to insulator (e.g., oxide) material 14' over the channel region, e.g., cSiGe layer 12d'. This process will also result in the formation of the notch or protuberance 14a at a transition between cSiGe material 12d' and the semiconductor-on-insulator material 12c, e.g., cSi.

As further shown in FIG. 2D, the mask layer 20 may be removed and shallow trench isolation structures 16, 16a may be formed in the structure 10. As should be understood, the shallow trench isolation structure 16 is provided at a boundary between the PFET region 100 and the NFET region 200. In embodiments, the shallow trench isolation structure 16 may be provided at a side of the notch or protuberance 14a, and may also be deeper than the shallow trench isolation structures 16a. Compared to conventional fabrication processes, the notch or protuberance 14a is preserved in the PFET region 100.

In embodiments, the shallow trench isolation structures 16, 16a can be formed by conventional lithography, etching and deposition methods known to those of skill in the art. For example, a resist formed over the insulator material 14, 14' is exposed to energy (light) and developed utilizing a conventional resist developer to form a pattern (openings). An etching process with a selective chemistry, e.g., reactive ion etching (RIE), will be used to transfer the pattern from the photoresist layer to the substrate 12 to form trenches. Following the resist removal by a conventional oxygen ashing process or other known stripants, the insulator material can be deposited by any conventional deposition processes, e.g., CVD processes to form the shallow trench isolation structures 16, 16a. The insulator material of the shallow trench isolation structures 16a may be planarized by a conventional CMP process. Additional insulator material can also be deposited by CVD on the surface of the insulator material 14, 14'.

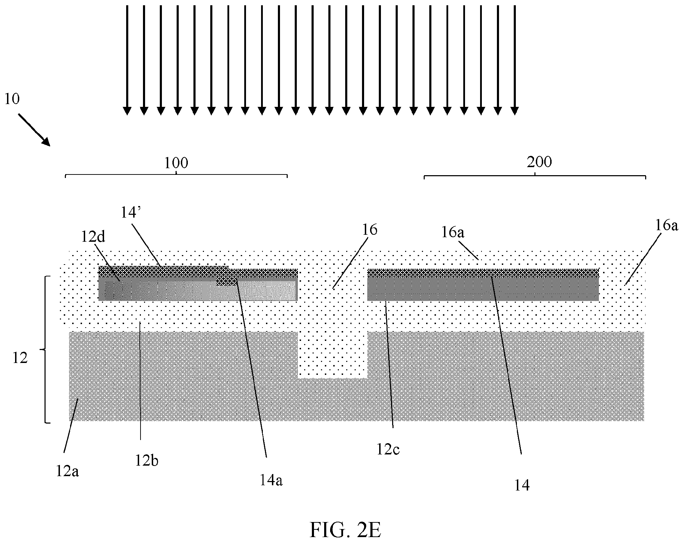

As shown in FIG. 2E, the structure undergoes an anneal process to blend or drive the cSiGe material 12d' into the channel region 12d of the PFET 100. In this way, it is possible to provide a laterally graded Ge% into the channel region 12d of the PFET region 100. In embodiments, the annealing process may be about 750° C and, more preferably about 800° C to 900° C, and more preferably between 900° C to 1100° C to provide or adjust a diffusion of Ge into the channel region. As the channel region of the NFET region 200, i.e., Si channel, remains protected from the cSiGe, this layer will remain a non-graded fully depleted semiconductor-on-insulator channel region.

In embodiments, the Ge% may be tuned along the width of the channel region (e.g., top semiconductor layer 12d) by adjusting the overlap of the insulator layer 14 and mask layer 20 and, more specifically, the mask layer 20. For example, adjusting the overlap to be greater over the PFET region 100, will result in less exposed semiconductor material on the PFET region 100. This, in turn, will result in less cSiGe material 22 epitaxially grown over the channel region of the PFET region 100 and, hence, a reduced concentration of Ge in the top semiconductor layer 12d. Following the anneal process, a lower Ge% will be provided at the boundary between the PFET region 100 and NFET region 200.

On the other hand, adjusting the overlap to be less over the PFET region 100 will result in more cSiGe material 22 (of FIG. 2B) epitaxially grown over the channel region of the PFET region 100 and, hence, increased a concentration of Ge in the top semiconductor layer 12d. This will result in a higher Ge% at the boundary between the PFET region 100 and NFET 200. In either scenario, due to the annealing process the Ge will diffuse into the cSi material and provide a lateral gradient of Ge% with a Ge% greatest at one end and lowest at an opposite end (e.g., nearest to the boundary of the PFET region 100 and the NFET region 200). Accordingly, the PFET region 100 can be tuned with different Ge% in the channel region of the PFET region 100.

Referring back to FIGS. 1A and 1B, the gate structures (gate material 18) for the PFET region 100 and NFET region 200 may be fabricated using conventional CMOS processes. For example, in conventional CMOS processing, a workfunction metal 18 may be deposited on the insulator material 14 by a conventional CVD process, followed by a conventional patterning process. In embodiments, the same or different gate materials 18, e.g., workfunction materials, can be used for the PFET region 100 and the NFET 200. In the case of using the same materials, the workfunction material(s) 18 for both the PFET region 100 and the NFET region 200 can be deposited and patterned at the same time. In the case of using different materials, the PFET region 100 and the NFET region 200 can be deposited and patterned in different fabrication processes.

Sidewall spacers may be formed on the sidewalls of the gate material(s) 18. In embodiments, the sidewall spacers may be a nitride material or combination of nitride and oxide, blanket deposited over the gate material(s) followed by an anisotropic etching process to form sidewall spacers as is known in the art such that no further explanation is required for a complete understanding of the present disclosure.

The structure can be utilized in system on chip (SoC) technology. The SoC is an integrated circuit (also known as a "chip") that integrates all components of an electronic system on a single chip or substrate. As the components are integrated on a single substrate, SoCs consume much less power and take up much less area than multichip designs with equivalent functionality. Because of this, SoCs are becoming the dominant force in the mobile computing (such as in Smartphones) and edge computing markets. SoC is also used in embedded systems and the Internet of Things.

The method(s) as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure comprising a PFET region comprising a laterally graded semiconductor channel region under a gate material.

2. The structure of claim 1, wherein the laterally graded semiconductor channel region comprises cSiGe.

3. The structure of claim 2, wherein the laterally graded semiconductor channel region comprises a laterally graded Ge% along a horizontal extent of the laterally graded semiconductor channel region.

4. The structure of claim 3, further comprising a notch extended within the laterally graded semiconductor channel region, wherein, optionally, the notch is at a transition between the cSiGe and cSi.

5. The structure of claim 4, further comprising a non-graded NFET region adjacent to the PFET region.

6. The structure of claim 2, further comprising an NFET region comprising a channel region of a non-graded fully depleted semiconductor-on-insulator material, wherein, optionally, the non-graded fully depleted semiconductor-on-insulator material comprises cSi.

7. The structure of claim 6, further comprising a shallow trench isolation structure isolating the PFET region from the NFET region.

8. The structure of claim 6 or 7, wherein a Ge% of the laterally graded semiconductor channel region comprising cSiGe is lower as it reaches a boundary between the PFET region and the NFET region.

9. The structure of one of claims 1 to 8, wherein the laterally graded semiconductor channel region comprises cSiGe with a Ge% greatest at one end and lowest at an opposite end, and a notch at an upper surface.

10. A structure comprising:
a PFET device with a channel region comprising a laterally graded semiconductor-on-insulator material;
another device with a channel region comprising a non-laterally graded semiconductor-on-insulator material; and
a trench isolation structure isolating the PFET device from the other device.

11. The structure of claim 10, wherein the laterally graded semiconductor-on-insulator material comprises cSiGe with an increasing Ge% along a length, and/or wherein e non-laterally graded semiconductor-on-insulator material comprises cSi.

12. The structure of claim 11, wherein the cSiGe transitions to cSi.

13. The structure of claim 12, further comprising a notch comprising insulator material extending into the cSiGe, wherein the notch is at a location where the cSiGe transitions to the cSi.

14. The structure of one of claims 11 to 13, wherein the Ge% is lowest at a boundary between the PFET device and the NFET device, and/or wherein the Ge% is greatest at one end and lowest at an opposite end nearest the NFET device.

15. A method comprising:
forming a PFET device with a channel region comprising a laterally graded semiconductor-on-insulator material;
forming an NFET device with a channel region comprising a non-laterally graded semiconductor-on-insulator material; and
forming a trench isolation structure isolating the PFET device from the NFET device.
